# EUROPEAN PATENT APPLICATION

(11) **EP 4 651 354 A1**
(43) Date of publication of application: **19.11.2025**
(21) Application number: 25175650.8
(22) Date of filing: 12.05.2025
(51) Int. Cl.: H02M 1/42, H02M 1/32, H02M 1/00, H02M 7/219

(54) **POWER MODULE**

(30) Priority: 13.05.2024 CN 202410594726
(71) Applicant: Huawei Digital Power Technologies Co., Ltd., Shenzhen, Guangdong 518043 (CN)
(72) Inventor: JIANG, Hua, Shenzhen, 518043 (CN)
(74) Representative: Isarpatent

(57) **Abstract**

Embodiments of this application provide a power module. The power module includes a bridgeless PFC circuit and a controller. The bridgeless PFC circuit includes a low-frequency module and a high-frequency module that are connected in parallel. The low-frequency module includes two low-frequency bridge arms that are connected in parallel. One low-frequency bridge arm includes two low-frequency switching transistors that are connected in series. The other low-frequency bridge arm includes two diodes that are connected in series. The controller is configured to turn off the low-frequency switching transistor in the one low-frequency bridge arm when an anode potential and a cathode potential of the diode in the other low-frequency bridge arm meet at least one of the following conditions: A difference obtained by subtracting the cathode potential from the anode potential is greater than a preset voltage value, and a difference obtained by subtracting the anode potential from the cathode potential is less than an opposite number of the preset voltage value. In embodiments provided in this application, when a reverse overcurrent flows into the bridgeless PFC circuit, a switching transistor in the bridgeless PFC circuit can be quickly turned off, to avoid damage to the switching transistor and improve reliability of the power module.

## Description

### TECHNICAL FIELD

This application relates to the circuit field, and more specifically, to a power module.

### BACKGROUND

With development of a power module toward environment protection, energy saving, and high efficiency, a power factor correction (power factor correction, PFC) circuit in the power module also develops toward high efficiency and high power density correspondingly. In a bridgeless PFC circuit, a switching transistor with a small turn-on voltage drop may be used to replace a low-frequency rectifier diode in a conventional bridged PFC circuit. Therefore, the bridgeless PFC circuit has higher efficiency and power density.

During actual application, the bridgeless PFC circuit is configured to receive an alternating current output by an alternating current power supply, and the switching transistor in the circuit may be controlled to be turned on or turned off to alternately charge and discharge an inductor in the circuit, to implement a rectification function of the bridgeless PFC circuit. However, a sudden change in a voltage of the alternating current power supply, a lightning strike, or other adverse working conditions on an input side of the bridgeless PFC circuit may cause a large reverse overcurrent to flow into the bridgeless PFC circuit through the input side of the circuit. Consequently, the switching transistor in the bridgeless PFC circuit is damaged, and reliability of the power module is affected.

### SUMMARY

This application provides a power module. When a reverse overcurrent flows into a bridgeless PFC circuit in the power module, a switching transistor in the bridgeless PFC circuit can be quickly turned off, to avoid damage to the switching transistor and improve reliability of the power module.

According to a first aspect, a power module is provided. The power module includes two input terminals, a bridgeless PFC circuit, and a controller. The two input terminals are configured to connect to an alternating current power supply. The bridgeless PFC circuit includes a low-frequency module and a high-frequency module. The low-frequency module and the high-frequency module are connected in parallel, and a switching frequency of a switching transistor in the low-frequency module is less than a switching frequency of a switching transistor in the high-frequency module. The low-frequency module includes two low-frequency bridge arms that are connected in parallel. One low-frequency bridge arm includes two low-frequency switching transistors that are connected in series. The other low-frequency bridge arm includes two diodes that are connected in series. A bridge arm midpoint of the one low-frequency bridge arm is connected to one input terminal. A bridge arm midpoint of the other low-frequency bridge arm and the high-frequency module are connected to the other input terminal. The controller is configured to turn off the low-frequency switching transistor in the one low-frequency bridge arm when an anode potential of the diode in the other low-frequency bridge arm and a cathode potential of the diode meet a preset condition. The preset condition includes at least one of the following conditions: A difference obtained by subtracting the cathode potential of the diode from the anode potential of the diode is greater than a preset voltage value, and a difference obtained by subtracting the anode potential of the diode from the cathode potential of the diode is less than an opposite number of the preset voltage value.

In this embodiment of this application, when the difference between the anode potential and the cathode potential of the diode in the low-frequency module is greater than the preset voltage value or less than the opposite number of the preset voltage value, in other words, when absolute values of voltages at two ends of the diode are greater than the preset voltage value, the controller may determine that a large reverse overcurrent flows into the bridgeless PFC circuit through the two input terminals, and therefore turn off a low-frequency switching transistor in an on state in the low-frequency module, to implement reverse overcurrent protection for the low-frequency switching transistor. This can avoid damage to the low-frequency switching transistor and improve reliability of the power module.

In addition, compared with a solution in which the controller detects a reverse overcurrent on an input side of the bridgeless PFC circuit by using a current sampling element to implement overcurrent protection for the low-frequency switching transistor, in this embodiment of this application, the controller implements overcurrent protection for the low-frequency switching transistor by detecting the difference between the anode potential and the cathode potential of the diode, and therefore the power module provided in this embodiment of this application may not be provided with a large-sized high-cost current sampling element. This helps reduce space occupied by the power module and reduce costs of the power module.

In an implementation, a drain of one low-frequency switching transistor is connected to a source of the other low-frequency switching transistor, a cathode of one diode is connected to an anode of the other diode, a source of the one low-frequency switching transistor and an anode of the one diode are connected and serve as one output end in a group of output ends of the bridgeless PFC circuit, and a drain of the other low-frequency switching transistor and a cathode of the other diode are connected and serve as the other output end in the group of output ends of the bridgeless PFC circuit. A phase voltage of the alternating current power supply includes two half-cycles, and the controller is configured to: when the phase voltage of the alternating current power supply falls within one half-cycle and the one low-frequency switching transistor is turned on, turn off the one low-frequency switching transistor when an anode potential of the one diode and a cathode potential of the one diode meet the preset condition; or when the phase voltage of the alternating current power supply falls within the other half-cycle and the other low-frequency switching transistor is turned on, turn off the other low-frequency switching transistor when an anode potential of the other diode and a cathode potential of the other diode meet the preset condition.

In this embodiment of this application, when the phase voltage of the alternating current power supply falls within different half-cycles, a low-frequency switching transistor in an on state in the low-frequency module varies. The controller may control, based on differences between cathode potentials and anode potentials of different diodes, a low-frequency switching transistor in an on state within a current half-cycle to be turned off. In this way, reverse overcurrent protection can be implemented for the low-frequency switching transistor in the low-frequency module within both half-cycles of the phase voltage of the alternating current power supply. This can avoid damage to the low-frequency switching transistor and improve reliability of the power module.

In an implementation, the anode of the one diode is grounded. That the controller is configured to turn off the one low-frequency switching transistor when an anode potential of the one diode and a cathode potential of the one diode meet the preset condition includes: turning off the one low-frequency switching transistor when a potential at the bridge arm midpoint of the other low-frequency bridge arm is less than the opposite number of the preset voltage value. That the controller is configured to turn off the other low-frequency switching transistor when an anode potential of the other diode and a cathode potential of the other diode meet the preset condition includes: turning off the other low-frequency switching transistor when a potential at the bridge arm midpoint of the other low-frequency bridge arm is greater than a sum of the preset voltage value and a potential at the other output end of the bridgeless PFC circuit.

In this embodiment of this application, the controller may determine, by detecting only the potential at the bridge arm midpoint of the other low-frequency bridge arm, whether a difference between a cathode potential and an anode potential of each diode in the low-frequency module meets the preset condition. Compared with a manner in which the controller detects potentials at two endpoints, that is, a cathode and an anode, of each diode to determine whether a difference between a cathode potential and an anode potential of each diode meets the preset condition, the foregoing manner helps reduce complexity of a circuit design for voltage sampling on the two diodes in the low-frequency module, and further reduce costs of the power module.

In an implementation, the bridge arm midpoint of the other low-frequency bridge arm is grounded. That the controller is configured to turn off the one low-frequency switching transistor when an anode potential of the one diode and a cathode potential of the one diode meet the preset condition includes: turning off the one low-frequency switching transistor when the anode potential of the one diode is greater than the preset voltage value. That the controller is configured to turn off the other low-frequency switching transistor when an anode potential of the other diode and a cathode potential of the other diode meet the preset condition includes: turning off the other low-frequency switching transistor when the cathode potential of the other diode is less than the opposite number of the preset voltage value.

In this embodiment of this application, the controller may determine, by detecting only the anode potential of the one diode or the cathode potential of the other diode in the low-frequency module, whether a difference between the cathode potential and the anode potential of the one diode or the other diode meets the preset condition. Compared with a manner in which the controller detects potentials at two endpoints, that is, a cathode and an anode, of each diode to determine whether a difference between a cathode potential and an anode potential of each diode meets the preset condition, the foregoing manner helps reduce complexity of a circuit design for voltage sampling on the two diodes in the low-frequency module, and further reduce costs of the power module.

In an implementation, the controller is further configured to: when the phase voltage of the alternating current power supply falls within the one half-cycle, turn on the one low-frequency switching transistor after the one low-frequency switching transistor is turned off for preset duration; or when the phase voltage of the alternating current power supply falls within the other half-cycle, turn on the other low-frequency switching transistor after the other low-frequency switching transistor is turned off for the preset duration.

In this embodiment of this application, a reverse overcurrent caused by a lightning strike or other adverse working conditions is usually a transient current. Therefore, the controller may turn off the low-frequency switching transistor in the low-frequency module for the preset duration and then turn on the low-frequency switching transistor again, to resume normal operation of the bridgeless PFC circuit and improve running stability of the power module.

In an implementation, the high-frequency module includes at least one high-frequency bridge arm, at least one inductor, and a capacitor. Each of the at least one high-frequency bridge arm includes two high-frequency switching transistors that are connected in series. Each high-frequency bridge arm is connected in parallel to the other low-frequency bridge arm and the capacitor. The at least one high-frequency bridge arm is in a one-to-one correspondence with the at least one inductor. A bridge arm midpoint of each high-frequency bridge arm is connected to the other input terminal through a corresponding inductor. In this way, quantities of high-frequency bridge arms and corresponding inductors in the bridgeless PFC circuit can be flexibly adjusted, to meet different actual application requirements.

In an implementation, the low-frequency module further includes a current-limiting resistor, and the current-limiting resistor is connected in series between the other input terminal and the bridge arm midpoint of the other low-frequency bridge arm. In this way, when a large forward surge current flows into the bridgeless PFC circuit through the two input terminals, the surge current can be limited by the current-limiting resistor, to implement surge protection for the bridgeless PFC circuit and improve reliability of the bridgeless PFC circuit.

In an implementation, when the alternating current power supply falls within the one half-cycle and the one low-frequency switching transistor is turned on, an alternating current output by the alternating current power supply sequentially flows through the other input terminal, the high-frequency module, the one low-frequency switching transistor, and the one input terminal, to form an operation loop of the bridgeless PFC circuit within the one half-cycle. When an alternating current output by the alternating current power supply sequentially flows through the one input terminal, the one low-frequency switching transistor, the one diode, and the other input terminal to form an overcurrent loop of the bridgeless PFC circuit within the one half-cycle, the cathode potential of the one diode and the anode potential of the one diode meet the preset condition.

In this embodiment of this application, when the alternating current power supply falls within the one half-cycle, for example, falls within a positive half-cycle, a current does not flow through the one diode during normal operation of the bridgeless PFC circuit, the one diode is reversely cut off, and absolute values of voltages at two ends of the one diode are less than a preset value. However, when a reverse overcurrent flows into the bridgeless PFC circuit and flows through the one diode, the anode potential of the one diode increases, and/or the cathode potential of the one diode decreases, so that absolute values of voltages at the two ends of the one diode are greater than the preset value. In this way, when the absolute values of the voltages at the two ends of the one diode are greater than the preset value, the controller may determine that a reverse overcurrent flows into the bridgeless PFC circuit, and therefore turn off the one low-frequency switching transistor in an on state, to implement overcurrent protection for the one low-frequency switching transistor.

In an implementation, when the alternating current power supply falls within the other half-cycle and the other low-frequency switching transistor is turned on, an alternating current output by the alternating current power supply sequentially flows through the one input terminal, the other low-frequency switching transistor, and the high-frequency module, to form an operation loop of the bridgeless PFC circuit within the other half-cycle. When an alternating current output by the alternating current power supply AC sequentially flows through the other input terminal, the other diode, the other low-frequency switching transistor, and the one input terminal to form an overcurrent loop of the bridgeless PFC circuit within the other half-cycle, the anode potential of the other diode and the cathode potential of the other diode meet the preset condition.

In this embodiment of this application, when the alternating current power supply falls within the other half-cycle, for example, falls within a negative half-cycle, a current does not flow through the other diode during normal operation of the bridgeless PFC circuit, the other diode is reversely cut off, and absolute values of voltages at two ends of the other diode are less than a preset value. However, when a reverse overcurrent flows into the bridgeless PFC circuit and flows through the other diode, the anode potential of the other diode increases, and/or the cathode potential of the other diode decreases, so that absolute values of voltages at the two ends of the other diode are greater than the preset voltage value. In this way, when the absolute values of the voltages at the two ends of the other diode are greater than the preset voltage value, the controller may determine that a reverse overcurrent flows into the bridgeless PFC circuit, and therefore turn off the other low-frequency switching transistor in an on state, to implement overcurrent protection for the other low-frequency switching transistor.

### BRIEF DESCRIPTION OF DRAWINGS

FIG. 1 is a diagram of a structure of an electronic device according to an embodiment of this application;
FIG. 2 is a diagram of a structure of another electronic device according to an embodiment of this application;
FIG. 3 is a diagram of a structure of a power module according to an embodiment of this application;
FIG. 4 is a diagram of a specific circuit structure of a power module shown in FIG. 3;
FIG. 5 is a diagram of a structure of a power module according to an embodiment of this application;
FIG. 6 to FIG. 9 are diagrams of a structure of an example power module according to an embodiment of this application;
FIG. 10 is a diagram of a structure of an example voltage detection circuit according to an embodiment of this application;
FIG. 11 to FIG. 17 are diagrams of a structure of an example power module according to an embodiment of this application; and
FIG. 18 is a diagram of a structure of another power module according to an embodiment of this application.

### DESCRIPTION OF EMBODIMENTS

For ease of understanding embodiments of this application, the following descriptions are provided before embodiments of this application are described.

In descriptions of embodiments of this application, a "connection" may be an electrical connection, and the electrical connection may be understood as a direct electrical connection or an indirect electrical connection between two electrical elements for implementing signal transmission. For example, that A is connected to B may be understood as that A is directly electrically connected to B, or may be understood as that A is indirectly electrically connected to B through one or more other electrical elements.

In descriptions of embodiments of this application, a "potential" may be a voltage between a specified point in a circuit and a zero-potential reference point. A potential lower than a zero potential is a negative potential, and a potential higher than the zero potential is a positive potential.

In descriptions of embodiments of this application, "a plurality of" means two or more, and "at least one" and "one or more" mean one, two, or more.

In addition, for ease of understanding, in accompanying drawings provided in embodiments of this application, a solid connection line represents a power transmission line, and a dashed connection line represents a signal transmission line.

The following describes technical solutions of this application with reference to accompanying drawings.

First, for ease of understanding technical solutions provided in embodiments of this application, an application scenario of embodiments of this application is described.

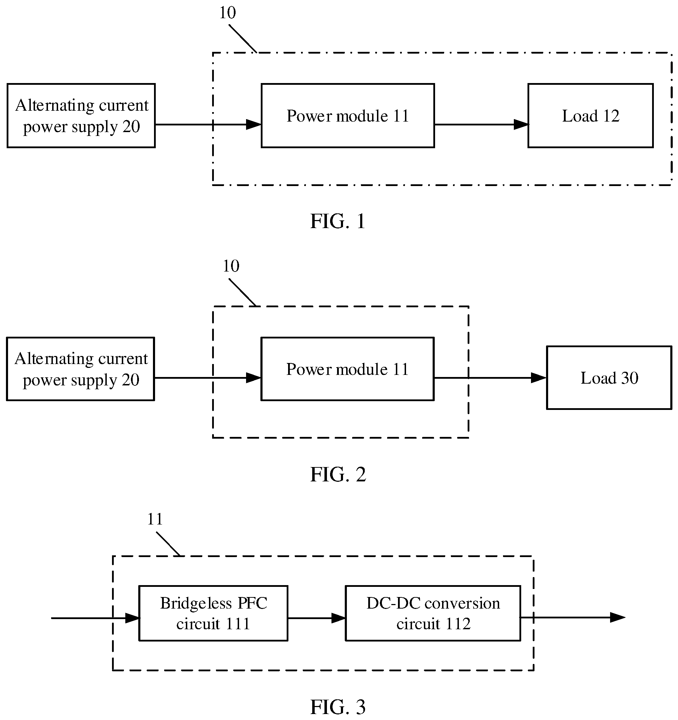

FIG. 1 is a diagram of a structure of an electronic device 10 according to an embodiment of this application.

As shown in FIG. 1, the electronic device 10 includes a power module 11 and a load 12. An input end of the power module 11 is configured to connect to an alternating current power supply 20. An output end of the power module 11 is connected to the load 12. The power module 11 is configured to receive an alternating current output by the alternating current power supply 20, convert the alternating current into a direct current, and output the direct current to the load 12, to supply power to the load 12.

For example, the electronic device 10 may be an electric device such as a base station or an electric vehicle. The load 12 may be an electric apparatus in the electronic device 10, for example, a power battery in an electric vehicle.

It should be understood that, in this embodiment of this application, the alternating current power supply 20 may be a power supply located inside the electronic device 10, or may be a power supply located outside the electronic device 10.

In some embodiments, the electronic device 10 includes one power module 11 and a plurality of loads 12, and the power module 11 may separately supply power to the plurality of loads 12. In some other embodiments, the electronic device 10 includes a plurality of power modules 11 and a plurality of loads 12, and the plurality of power modules 11 may respectively supply power to the plurality of loads 12.

FIG. 2 is a diagram of a structure of another electronic device 10 according to an embodiment of this application.

As shown in FIG. 2, the electronic device 10 includes a power module 11. An input end of the power module 11 is configured to connect to an alternating current power supply 20. An output end of the power module 11 is configured to connect to a load 30 located outside the electronic device 10. The power module 11 is configured to receive an alternating current output by the alternating current power supply 20, convert the alternating current into a direct current, and output the direct current to the load 30, to supply power to the load 30.

For example, the electronic device 10 may be a power supply device such as a power adapter, a charging pile, or a mobile power supply. The adapter (adapter) may also be referred to as a charger (charger), a charging head, a switch power supply (switch power supply), a power converter (power converter), or the like. The load 30 may be, for example, an electronic device such as a mobile phone, a computer, or an electric vehicle.

For related descriptions of the power module 11 and the alternating current power supply 20, refer to the embodiment shown in FIG. 1. Details are not described herein again.

FIG. 3 is a diagram of an example structure of the power module 11 shown in FIG. 1 and FIG. 2.

As shown in FIG. 3, the power module 11 includes a bridgeless PFC circuit 111 and a direct current-direct current (direct current-direct current, DC-DC) conversion circuit 112.

An input end of the bridgeless PFC circuit 111 is configured to connect to an alternating current power supply 20. An output end of the bridgeless PFC circuit 111 is connected to an input end of the DC-DC conversion circuit 112. An output end of the DC-DC conversion circuit 112 is configured to connect to a load, for example, is configured to connect to the load 12 shown in FIG. 1 or the load 30 shown in FIG. 2.

During specific implementation, the bridgeless PFC circuit 111 is configured to convert an alternating current output by the alternating current power supply 20 into a direct current, perform power factor correction on the direct current, and output the direct current to the DC-DC conversion circuit 112.

For example, a voltage value of the direct current output by the bridgeless PFC circuit 111 to the DC-DC conversion circuit 112 is greater than a voltage value of the alternating current obtained by the bridgeless PFC circuit 111 from the alternating current power supply 20, or a voltage value of the direct current output by the bridgeless PFC circuit 111 to the DC-DC conversion circuit 112 may be equal to a voltage value of the alternating current obtained by the bridgeless PFC circuit 111 from the alternating current power supply 20.

The DC-DC conversion circuit 112 is configured to receive the direct current output by the bridgeless PFC circuit 111, and further convert the received direct current into a direct current applicable to the load, and output the direct current to the load.

For example, the DC-DC conversion circuit 112 may be an isolated DC-DC conversion circuit. For example, the DC-DC conversion circuit 112 may be an asymmetrical half-bridge (asymmetrical half-bridge, AHB) flyback conversion circuit or an active clamp flyback (active clamp flyback, ACF) conversion circuit. Alternatively, the DC-DC conversion circuit 112 may be a non-isolated DC-DC conversion circuit. For example, the DC-DC conversion circuit 112 may be one of a boost (boost) circuit, a buck (buck) circuit, or a boost-boost (buck-boost) circuit.

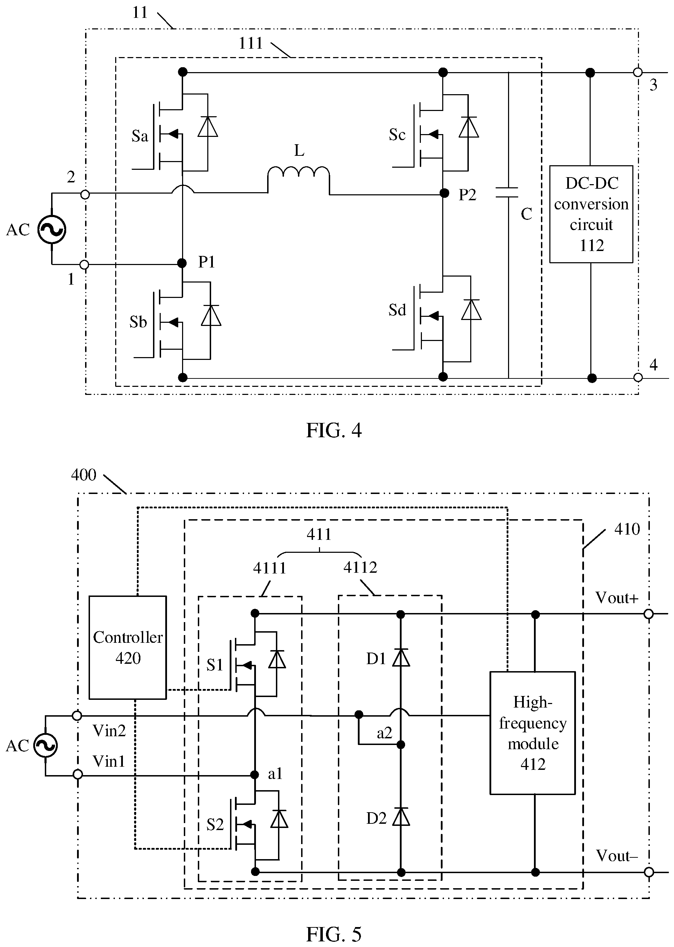

FIG. 4 is a diagram of an example specific circuit structure of the power module 11 shown in FIG. 3.

As shown in FIG. 4, the power module 11 further includes a group of input terminals and a group of output terminals. The group of input terminals includes an input terminal 1 and an input terminal 2. The group of output terminals includes an output terminal 3 and an output terminal 4. The bridgeless PFC circuit 111 includes a low-frequency bridge arm, a high-frequency bridge arm, an inductor L, and a capacitor C. In addition, the low-frequency bridge arm includes two switching transistors Sa and Sb that are connected in series, and the high-frequency bridge arm includes two switching transistors Sc and Sd that are connected in series.

The input terminal 1 and the input terminal 2 are configured to connect to two output terminals in a group of output terminals of an alternating current power supply (alternating current, AC) in a one-to-one correspondence. The output terminal 3 and the output terminal 4 are configured to connect to a load. A bridge arm midpoint P1 of the low-frequency bridge arm and one end of the inductor L serve as two input ends in a group of input ends of the bridgeless PFC circuit 111, and are connected to the input terminal 1 and the input terminal 2 in a one-to-one correspondence. The other end of the inductor L is connected to a bridge arm midpoint P2 of the high-frequency bridge arm. Two ends of the low-frequency bridge arm, the high-frequency bridge arm, and the capacitor C that are connected in parallel serve as two output ends in a group of output ends of the bridgeless PFC circuit 111, and are connected to the output terminal 3 and the output terminal 4 in a one-to-one correspondence.

It should be understood that, in this embodiment of this application, the bridgeless PFC circuit 111 may include one or more high-frequency bridge arms. For example, FIG. 4 shows an example in which the bridgeless PFC circuit 111 operates with a single-phase high-frequency bridge arm. In some other embodiments, the bridgeless PFC circuit 111 may alternatively operate with two high-frequency bridge arms with a phase difference of 180°. Alternatively, the bridgeless PFC circuit 111 may operate with three high-frequency bridge arms with a phase difference of 120°.

It should be further understood that, in this embodiment of this application, the switching transistor may be a plurality of types of power switching transistors such as a metal-oxide semiconductor field-effect transistor (metal-oxide semiconductor field-effect transistor, MOSFET), a bipolar junction transistor (bipolar junction transistor, BJT), an insulated gate bipolar transistor (insulated gate bipolar transistor, IGBT), and a silicon carbide (SiC) transistor. For ease of description and understanding, an example in which the switching transistor is an MOSFET is used for description in this embodiment of this application.

The following describes an operation principle of a bridgeless PFC circuit by using an example in which the bridgeless PFC circuit 111 shown in FIG. 4 operates with the single-phase high-frequency bridge arm.

When a phase voltage of the alternating current power supply AC falls within a positive half-cycle, the input terminal 1 is negative, and the input terminal 2 is positive. In this case, the switching transistor Sa in the low-frequency bridge arm is turned off, the switching transistor Sb is turned on, the switching transistor Sd in the high-frequency bridge arm serves as a primary transistor, and the switching transistor Sc serves as a synchronous transistor. Within time in which the switching transistor Sd is turned on and the switching transistor Sc is turned off, a current in the bridgeless PFC circuit 111 sequentially passes through the input terminal 2 → the inductor L → the switching transistor Sd → the switching transistor Sb → the input terminal 1. In this case, the inductor L stores energy. Within time in which the switching transistor Sd is turned off and the switching transistor Sc is turned on, a current loop in the bridgeless PFC circuit 111 sequentially passes through the input terminal 2 → the inductor L → the switching transistor Sc → the capacitor C → the switching transistor Sb → the input terminal 1. In this case, the inductor L outputs energy. The alternating current power supply AC and the inductor L charge the capacitor C.

Similarly, when a phase voltage of the alternating current power supply AC falls within a negative half-cycle, the input terminal 1 is positive, and the input terminal 2 is negative. In this case, the switching transistor Sa in the low-frequency bridge arm is turned on, the switching transistor Sb is turned off, the switching transistor Sc in the high-frequency bridge arm serves as a primary transistor, and the switching transistor Sd serves as a synchronous transistor. Within time in which the switching transistor Sc is turned on and the switching transistor Sd is turned off, a current in the bridgeless PFC circuit 111 sequentially passes through the input terminal 1 → the switching transistor Sa → the switching transistor Sc → the inductor L → the input terminal 2. In this case, the inductor L stores energy. Within time in which the switching transistor Sc is turned off and the switching transistor Sd is turned on, a current in the bridgeless PFC circuit 111 sequentially passes through the input terminal 1 → the switching transistor Sa → the capacitor C → the switching transistor Sd → the inductor L → the input terminal 2. In this case, the inductor L outputs energy. The alternating current power supply AC and the inductor L charge the capacitor C.

In this way, when the phase voltage of the alternating current power supply AC falls within different half-cycles, a corresponding switching transistor in the bridgeless PFC circuit 111 may be controlled to be turned off or turned on to alternately charge and discharge the inductor L, to implement a rectification function of the bridgeless PFC circuit 111 and a power factor correction function.

However, as described in the background, during operation of the bridgeless PFC circuit 111, a sudden change in the phase voltage of the alternating current power supply AC, a lightning strike, or other adverse working conditions may cause a transient reverse overcurrent to flow into the bridgeless PFC circuit 111. For example, when the phase voltage of the alternating current power supply AC falls within the positive half-cycle and the switching transistor Sb is turned on, a large reverse overcurrent may flow into the switching transistor Sb through the input terminal 1 due to a lightning strike or other adverse working conditions. The large reverse overcurrent is likely to damage the switching transistor Sb. Consequently, reliability of the power module 11 is affected.

Based on the foregoing content, embodiments of this application provide a power module. When a reverse overcurrent flows into a bridgeless PFC circuit in the power module, a switching transistor in the bridgeless PFC circuit can be quickly turned off, to avoid damage to the switching transistor and improve reliability of the power module.

FIG. 5 is a diagram of a structure of a power module 400 according to an embodiment of this application. It should be understood that the power module 400 may be the power module 11 shown in FIG. 1 to FIG. 3.

As shown in FIG. 5, the power module 400 includes two input terminals Vin1 and Vin2, a bridgeless PFC circuit 410, a controller 420, and two output terminals Vout+ and Vout-. The two input terminals Vin1 and Vin2 are configured to connect to an alternating current power supply AC. The two output terminals Vout+ and Vout- are configured to connect to a load. The bridgeless PFC circuit 410 includes a low-frequency module 411 and a high-frequency module 412. The low-frequency module 411 and the high-frequency module 412 are connected in parallel and then connected between the two output terminals Vout+ and Vout-, and a switching frequency of a switching transistor in the low-frequency module 411 is less than a switching frequency of a switching transistor in the high-frequency module 412.

The low-frequency module 411 includes two low-frequency bridge arms that are connected in parallel, to be specific, includes a low-frequency bridge arm 4111 and a low-frequency bridge arm 4112 that are connected in parallel. The low-frequency bridge arm 4111 includes two low-frequency switching transistors S1 and S2 that are connected in series. The low-frequency bridge arm 4112 includes two diodes D1 and D2 that are connected in series. A bridge arm midpoint a1 of the low-frequency bridge arm 4111 is connected to the input terminal Vin1. A bridge arm midpoint a2 of the low-frequency bridge arm 4112 and the high-frequency module 412 are connected to the input terminal Vin2.

During specific implementation, the bridgeless PFC circuit 410 receives, through the two input terminals Vin1 and Vin2, an alternating current output by the alternating current power supply AC, and the low-frequency module 411 and the high-frequency module 412 are configured to convert the received alternating current into a direct current, perform power factor correction on the direct current, and output the direct current to the load through the two output terminals Vout+ and Vout-.

In some embodiments, the power module 400 further includes a DC-DC conversion circuit (not shown in the figure). The DC-DC conversion circuit is connected in parallel to the low-frequency module 411 and the high-frequency module 412, and then connected to the two output terminals Vout+ and Vout-. The DC-DC conversion circuit is configured to perform power conversion on the direct current output by the bridgeless PFC circuit 410, and then output the direct current to the load through the two output terminals Vout+ and Vout-. For specific descriptions, refer to the embodiment shown in FIG. 3. Details are not described herein again.

It should be understood that, in this embodiment of this application, a phase voltage of the alternating current power supply AC includes two half-cycles. Current directions of alternating currents output by the alternating current power supply AC to the power module 400 in the two half-cycles are opposite. Specifically, when the phase voltage of the alternating current power supply AC falls within one half-cycle, an alternating current output by the alternating current power supply AC flows into the power module 400 through the input terminal Vin2, and flows back to the alternating current power supply AC through the input terminal Vin1. To be specific, the input terminal Vin1 is negative, and the input terminal Vin2 is positive. When the phase voltage of the alternating current power supply AC falls within the other half-cycle, an alternating current output by the alternating current power supply AC flows into the power module 400 through the input terminal Vin1, and flows back to the alternating current power supply AC through the input terminal Vin2. To be specific, the input terminal Vin1 is positive, and the input terminal Vin2 is negative. That is, the two half-cycles are respectively a positive half-cycle and a negative half-cycle of the phase voltage of the alternating current power supply AC.

For ease of description and understanding, in this embodiment of this application, descriptions are provided by using an example in which the one half-cycle is the positive half-cycle of the phase voltage of the alternating current power supply AC and the other half-cycle is the negative half-cycle of the phase voltage of the alternating current power supply AC.

Still as shown in FIG. 5, the controller 420 is separately connected to the low-frequency module 411 and the high-frequency module 412. The controller 420 is configured to: when the phase voltage of the alternating current power supply AC falls within different half-cycles, determine, based on whether a difference between an anode potential and a cathode potential of the diode in the low-frequency bridge arm 4112 meets a preset condition, whether a reverse overcurrent flows into the bridgeless PFC circuit 410 through the two input terminals Vin1 and Vin2. The preset condition includes at least one of the following conditions: A difference obtained by subtracting the cathode potential of the diode from the anode potential of the diode is greater than a preset voltage value, and a difference obtained by subtracting the anode potential of the diode from the cathode potential of the diode is less than an opposite number of the preset voltage value.

It should be understood that, in this embodiment of this application, both the difference obtained by subtracting the cathode potential of the diode from the anode potential of the diode and the difference obtained by subtracting the anode potential of the diode from the cathode potential of the diode may be understood as voltages at two ends of the diode, and therefore the preset condition may also be understood as that absolute values of the voltages at the two ends of the diode are greater than the preset voltage value.

Further, the controller 420 is configured to: when the anode potential and the cathode potential of the diode in the low-frequency bridge arm 4112 meet the preset condition, determine that a reverse overcurrent flows into the bridgeless PFC circuit 410, and therefore turn off a low-frequency switching transistor in an on state in the low-frequency bridge arm 4111, to implement reverse overcurrent protection for the low-frequency switching transistor. This can avoid damage to the low-frequency switching transistor and improve reliability of the power module 400.

For example, the controller 420 includes a discrete element or a logic device.

It should be understood that, in some solutions, the controller 420 detects a current on an input side of the bridgeless PFC circuit 410 by using a current sampling element such as a Hall effect sensor or an industrial-frequency current transformer, and when a large reverse overcurrent is detected, controls the low-frequency switching transistor in the low-frequency module 411 to be quickly turned off, to implement overcurrent protection for the low-frequency switching transistor. However, the current sampling element such as the Hall effect sensor or the industrial-frequency current transformer usually has a large size and high costs. This is not conducive to a miniaturization and low-cost design of the power module 400.

In this embodiment of this application, the controller 420 implements overcurrent protection for the low-frequency switching transistor in the low-frequency module 411 by detecting the difference between the anode potential and the cathode potential of the diode in the low-frequency module 411, and therefore the power module 400 may not be provided with the current sampling element. This helps reduce space occupied by the power module 400 and reduce costs of the power module 400.

An operation principle of overcurrent protection for the low-frequency switching transistor in the bridgeless PFC circuit 410 provided in this embodiment of this application is specifically described below by using a specific circuit as an example.

Still as shown in FIG. 5, in some embodiments, a drain of the low-frequency switching transistor S2 is connected to a source of the low-frequency switching transistor S1 to form the bridge arm midpoint a1 of the low-frequency bridge arm 4111, and a cathode of the diode D2 is connected to an anode of the diode D1 to form the bridge arm midpoint a2 of the low-frequency bridge arm 4112. In addition, a source of the low-frequency switching transistor S2 is connected to an anode of the diode D2 and one end of the high-frequency module 412, and a drain of the low-frequency switching transistor S1 is connected to a cathode of the diode D1 and another end of the high-frequency module 412.

It should be understood that, during specific implementation, the bridgeless PFC circuit 410 includes a group of output ends, and the group of output ends includes a positive output end and a negative output end. A first common end of the source of the low-frequency switching transistor S2, the anode of the diode D2, and the one end of the high-frequency module 412 that are connected may be one of the positive output end and the negative output end, and a second common end of the drain of the low-frequency switching transistor S1, the cathode of the diode D1, and the another end of the high-frequency module 412 that are connected may be the other one of the positive output end and the negative output end.

For ease of description and understanding, in this embodiment of this application, descriptions are provided by using an example in which the first common end is the negative output end of the bridgeless PFC circuit 410 and is configured to connect to the output terminal Vout- of the power module 400, and the second common end is the positive output end of the bridgeless PFC circuit 410 and is configured to connect to the output terminal Vout+ of the power module 400.

In an example, when the phase voltage of the alternating current power supply AC falls within one half-cycle, the low-frequency switching transistor S2 is turned on, and an alternating current output by the alternating current power supply AC sequentially flows through the input terminal Vin2, the high-frequency module 412, the low-frequency switching transistor S2, and the input terminal Vin1, to form an operation loop of the bridgeless PFC circuit 410 within the one half-cycle.

In this case, the controller 420 is configured to: detect a difference between an anode potential and a cathode potential of the diode D2, and when the difference is greater than the preset voltage value or less than the opposite number of the preset voltage value, determine that an overcurrent flows into the bridgeless PFC circuit 410, and therefore turn off the low-frequency switching transistor S2, to implement reverse overcurrent protection for the low-frequency switching transistor S2.

In another example, when the phase voltage of the alternating current power supply AC falls within the other half-cycle, the low-frequency switching transistor S1 is turned on, and an alternating current output by the alternating current power supply AC sequentially flows through the input terminal Vin1, the low-frequency switching transistor S1, the high-frequency module 412, and the input terminal Vin2, to form an operation loop of the bridgeless PFC circuit 410 within the other half-cycle.

In this case, the controller 420 is configured to: detect a difference between an anode potential and a cathode potential of the diode D1, and when the difference is greater than the preset voltage value or less than the opposite number of the preset voltage value, determine that an overcurrent flows into the bridgeless PFC circuit 410, and therefore turn off the low-frequency switching transistor S1, to implement reverse overcurrent protection for the low-frequency switching transistor S1.

The following describes different cases in which the controller 420 turns off the low-frequency switching transistor S2 and the low-frequency switching transistor S1 separately.

**Case 1: The controller 420 turns off the low-frequency switching transistor S2 when the phase voltage of the alternating current power supply AC falls within one half-cycle.**

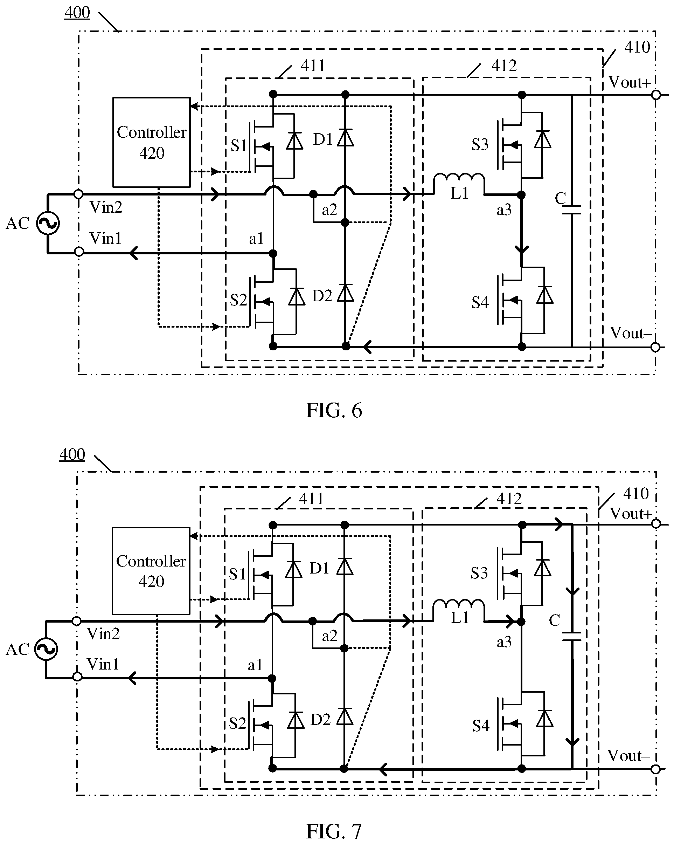

FIG. 6 to FIG. 8 are diagrams of a structure of an example power module 400 according to an embodiment of this application.

With reference to FIG. 6 to FIG. 8, in some embodiments, the high-frequency module 412 includes at least one high-frequency bridge arm, at least one inductor, and a capacitor, and each high-frequency bridge arm includes two high-frequency switching transistors that are connected in series. The at least one high-frequency bridge arm is in a one-to-one correspondence with the at least one inductor. An end, at which a bridge arm midpoint of each high-frequency bridge arm is connected to a corresponding inductor, is connected to the input terminal Vin2 through the corresponding inductor. In addition, each high-frequency bridge arm is further connected in parallel to the low-frequency bridge arm 4111, the low-frequency bridge arm 4112, and the capacitor, and then connected between the two output terminals Vout+ and Vout-. It should be understood that, for ease of description and understanding, an example in which the high-frequency module 412 includes one high-frequency bridge arm and one inductor is used for description in this embodiment of this application.

Specifically, still as shown in FIG. 6 to FIG. 8, the high-frequency module 412 includes one high-frequency bridge arm and one inductor L1, and the high-frequency bridge arm includes two high-frequency switching transistors S3 and S4 that are connected in series. A drain of the high-frequency switching transistor S4 is connected to a source of the high-frequency switching transistor S3 to form a bridge arm midpoint a3 of the high-frequency bridge arm. The bridge arm midpoint a3 is connected to the input terminal Vin2 through the inductor L1. In addition, a first common end of a source of the high-frequency switching transistor S4, the anode of the diode D2, the source of the low-frequency switching transistor S2, and one end of the capacitor C that are connected serves as a negative output end of the bridgeless PFC circuit 410 and is connected to the output terminal Vout- of the power module 400. A second common end of a drain of the high-frequency switching transistor S3, the cathode of the diode D1, the drain of the low-frequency switching transistor S1, and the other end of the capacitor C that are connected serves as a positive output end of the bridgeless PFC circuit 410 and is connected to the output terminal Vout+ of the power module 400.

When the phase voltage of the alternating current power supply AC falls within one half-cycle and the low-frequency switching transistor S2 is turned on, as shown in FIG. 6, an alternating current output by the alternating current power supply AC sequentially flows through the input terminal Vin2 → the inductor L1 → the high-frequency switching transistor S4 → the low-frequency switching transistor S2 → the input terminal Vin1, to form an operation loop of the inductor L1 for energy storage within the one half-cycle. Alternatively, as shown in FIG. 7, an alternating current output by the alternating current power supply AC sequentially flows through the input terminal Vin2 → the inductor L1 → the high-frequency switching transistor S3 → the capacitor C → the low-frequency switching transistor S2 → the input terminal Vin1, to form an operation loop of the inductor L1 for energy output within the one half-cycle.

In the operation loops of the inductor L1 for energy storage and energy output, the anode potential U_{D2} anode of the diode D2 is less than the cathode potential U_{D2 cathode} of the diode D2, and the diode D2 is reversely cut off. In this case, a difference obtained by subtracting the cathode potential U_{D2 cathode} of the diode D2 from the anode potential U_{D2 anode} of the diode D2 is less than the preset voltage value, and a difference obtained by subtracting the anode potential U_{D2 anode} of the diode D2 from the cathode potential U_{D2 cathode} of the diode D2 is greater than the opposite number of the preset voltage value: U_{D2 anode} - U_{D2 cathode} < the preset voltage value, and U_{D2 cathode} - U_{D2 anode} > - the preset voltage value. To be specific, absolute values of voltages at two ends of the diode D2 are less than the preset voltage value.

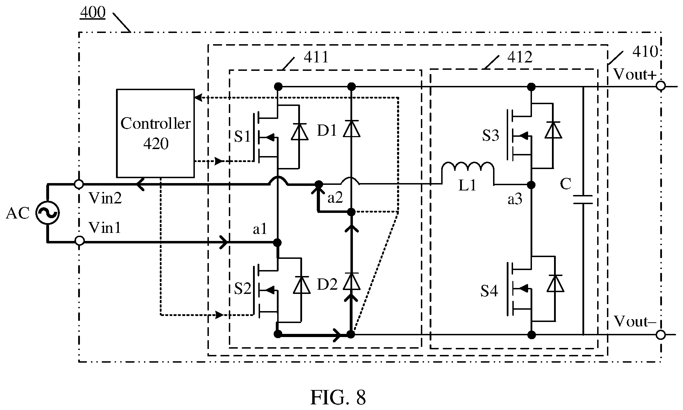

As shown in FIG. 8, if a reverse overcurrent is generated at the alternating current power supply AC connected to the power module 400, the reverse overcurrent sequentially flows through the input terminal Vin1, the low-frequency switching transistor S2, the diode D2, and the input terminal Vin2, to form an overcurrent loop.

During the formation of the overcurrent loop, the anode potential U_{D2 anode} of the diode D2 increases, and/or the cathode potential U_{D2 cathode} of the diode D2 decreases, and the anode potential U_{D2 anode} of the diode D2 is greater than the cathode potential U_{D2 cathode} of the diode D2, so that the diode D2 is turned on in a forward direction. In the foregoing process in which the diode D2 is turned on in the forward direction due to the reverse overcurrent, the anode potential U_{D2 anode} of the diode D2 increases, and/or the cathode potential U_{D2 cathode} of the diode D2 decreases, so that a difference obtained by subtracting the cathode potential of the diode D2 from the anode potential of the diode D2 is greater than the preset voltage value, and a difference obtained by subtracting the anode potential of the diode D2 from the cathode potential of the diode D2 is less than the opposite number of the preset voltage value: U_{D2 anode} - U_{D2 cathode} > the preset voltage value, and U_{D2 cathode} - U_{D2 anode} < - the preset voltage value. To be specific, absolute values of voltages at two ends of the diode D2 are greater than the preset voltage value.

It should be understood that, in this embodiment of this application, the preset voltage value may be a positive voltage value, a negative voltage value, or 0 V.

For example, it is assumed that the preset voltage value is -10 V. When the phase voltage of the alternating current power supply AC falls within one half-cycle and the low-frequency switching transistor S2 is turned on, if no reverse overcurrent flows into the bridgeless PFC circuit 410, the anode potential U_{D2 anode} of the diode D2 is 0 V, the cathode potential U_{D2 cathode} of the diode D2 is 15 V, and the diode D2 is reversely cut off. In this case, U_{D2 anode} - U_{D2 cathode} = -15 V < the preset voltage value, and U_{D2 cathode} - U_{D2 anode} = 15 V > - the preset voltage value. The difference between the anode potential and the cathode potential of the diode D2 does not meet the foregoing preset condition.

If a reverse overcurrent flows into the bridgeless PFC circuit 410 to form the foregoing overcurrent loop, the anode potential U_{D2 anode} of the diode D2 remains unchanged, and the cathode potential U_{D2 cathode} of the diode D2 decreases to be lower than the anode potential U_{D2 anode} of the diode D2. During the decrease of the cathode potential U_{D2 cathode} of the diode D2, for example, when the cathode potential U_{D2 cathode} of the diode D2 decreases to 8 V, U_{D2 anode} - U_{D2 cathode} = -8 V > the preset voltage value, and U_{D2 cathode} - U_{D2 anode} = 8 V < - the preset voltage value. To be specific, the anode potential U_{D2 anode} and the cathode potential of the diode D2 meet the foregoing preset condition.

In this way, when the difference obtained by subtracting the cathode potential U_{D2 cathode} of the diode D2 from the anode potential U_{D2 anode} of the diode D2 is -8 V, or when the difference obtained by subtracting the anode potential U_{D2 anode} of the diode D2 from the cathode potential U_{D2 cathode} of the diode D2 is 8 V, the controller 420 may determine that a reverse overcurrent flows into the bridgeless PFC circuit 410, and therefore turn off the low-frequency switching transistor S2, to implement overcurrent protection for the low-frequency switching transistor S2.

Further, in some embodiments, the controller 420 is further configured to: when the phase voltage of the alternating current power supply AC falls within one half-cycle, turn on the low-frequency switching transistor S2 after the low-frequency switching transistor S2 is turned off for preset duration.

It should be understood that a reverse overcurrent caused by a lightning strike or other adverse working conditions is usually a transient current, and therefore the controller 420 may turn off the low-frequency switching transistor S2 for the preset duration and then turn on the low-frequency switching transistor S2 again, to resume normal operation of the bridgeless PFC circuit 410 and improve running stability of the power module 400.

It should be further understood that, in this embodiment of this application, when the bridgeless PFC circuit 410 is grounded through different endpoints, the controller 420 may directly determine, based on the cathode potential or the anode potential of the diode D2, whether the difference between the anode potential and the cathode potential of the diode D2 meets the foregoing preset condition.

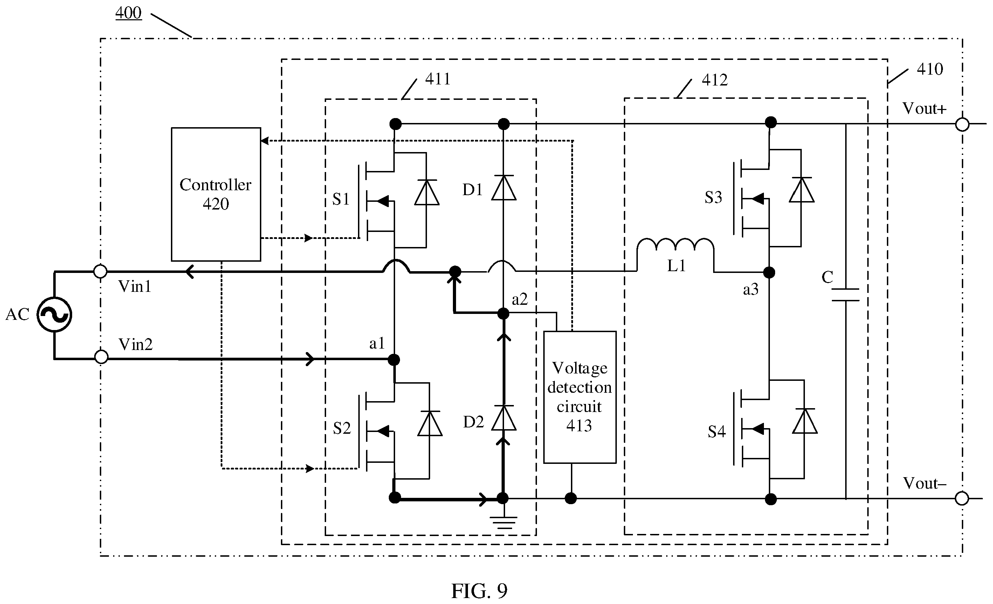

For example, FIG. 9 is a diagram of a structure of an example power module 400 according to an embodiment of this application.

As shown in FIG. 9, in some embodiments, the anode of the diode D2 is grounded. To be specific, the anode potential U_{D2 anode} of the diode D2 is 0 V. In this case, the controller 420 is configured to: when the phase voltage of the alternating current power supply AC falls within one half-cycle and the low-frequency switching transistor S2 is turned on, turn off the low-frequency switching transistor S2 when a potential at the bridge arm midpoint a2 of the low-frequency bridge arm 4112 is less than the opposite number of the preset voltage value, to implement reverse overcurrent protection for the low-frequency switching transistor S2.

Specifically, with reference to the embodiments shown in FIG. 6 and FIG. 7, it can be learned that, when the phase voltage of the alternating current power supply AC falls within one half-cycle and the low-frequency switching transistor S2 is turned on, if no reverse overcurrent flows into the bridgeless PFC circuit 410, the anode potential U_{D2 anode} of the diode D2 is less than the cathode potential U_{D2 cathode} of the diode D2, U_{D2 anode} - U_{D2 cathode} < the preset voltage value, and U_{D2 cathode} - U_{D2 anode} > - the preset voltage value. Because the anode potential U_{D2 anode} of the diode D2 is 0 V, the cathode potential U_{D2 cathode} of the diode D2 is greater than the opposite number of the preset voltage value. To be specific, the potential Uₐ₂ at the bridge arm midpoint a2 is greater than the opposite number of the preset voltage value: Uₐ₂ > - the preset voltage value.

With reference to the embodiment shown in FIG. 8, it can be learned that, if a reverse overcurrent flows into the bridgeless PFC circuit 410, the cathode potential U_{D2 cathode} of the diode D2 decreases, so that U_{D2 anode} - U_{D2 cathode} > the preset voltage value, and U_{D2 cathode} - U_{D2 anode} < - the preset voltage value. Similarly, because the anode potential U_{D2 anode} of the diode D2 is 0 V, the cathode potential U_{D2 cathode} of the diode D2 is less than the opposite number of the preset voltage value. To be specific, the potential at the bridge arm midpoint a2 is less than the opposite number of the preset voltage value: Uₐ₂ < - the preset voltage value.

It can be learned from the foregoing analysis that, when the anode of the diode D2 is grounded, the controller 420 may determine, by detecting the potential Uₐ₂ at the bridge arm midpoint a2, whether the difference between the anode potential and the cathode potential of the diode D2 meets the foregoing preset condition. Compared with a manner in which the controller 420 detects voltages at two endpoints, that is, the cathode and the anode, of the diode D2 to determine whether the difference between the anode potential and the cathode potential of the diode D2 meets the foregoing preset condition, the foregoing manner helps reduce complexity of a circuit design for voltage sampling on the diode D2, and further reduce costs of the power module 400.

Still as shown in FIG. 9, in some embodiments, the bridgeless PFC circuit 410 further includes a voltage detection circuit 413. The voltage detection circuit 413 is configured to: detect the potential at the bridge arm midpoint a2, and output a level-inverted signal to the controller 420 when the potential at the bridge arm midpoint a2 changes from being greater than the opposite number of the preset voltage value to being less than the opposite number of the preset voltage value, so that the controller 420 determines, based on the level-inverted signal, that a voltage at the bridge arm midpoint a2 is less than the opposite number of the preset voltage value, and therefore turns off the low-frequency switching transistor S2.

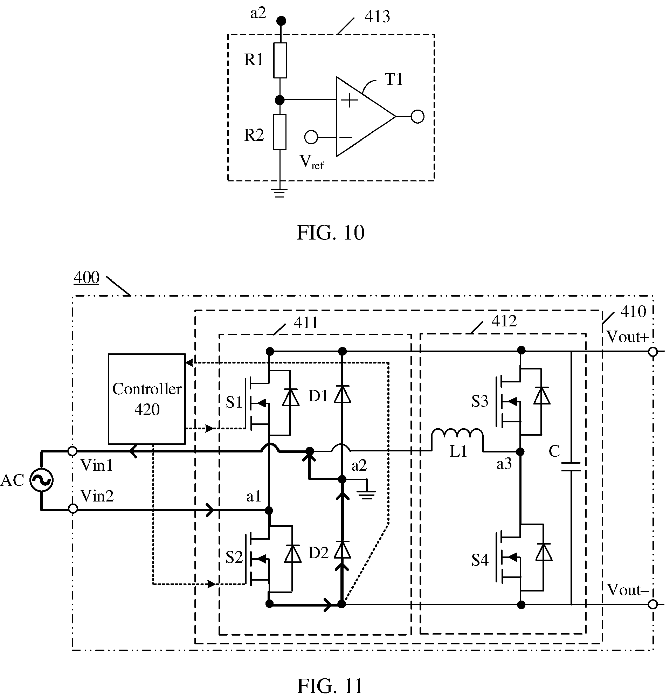

FIG. 10 is a diagram of a structure of an example voltage detection circuit 413 according to an embodiment of this application.

With reference to FIG. 9 and FIG. 10, the voltage detection circuit 413 includes two resistors R1 and R2 and a comparator T1. One end of the resistor R1 is connected to the bridge arm midpoint a2, and the other end of the resistor R1 is grounded through the resistor R2. A voltage between the resistor R1 and the resistor R2 serves as a non-inverting input signal for the comparator T1. A reference voltage V_{ref} serves as an inverting input signal for the comparator T1.

The following describes an operation principle of the voltage detection circuit 413 by using an example in which both the preset voltage value and the reference voltage V_{ref} are 0 V.

When the phase voltage of the alternating current power supply AC falls within one half-cycle and the low-frequency switching transistor S2 is turned on, if no reverse overcurrent flows into the bridgeless PFC circuit 410, the potential Uₐ₂ at the bridge arm midpoint a2 is greater than the opposite number of the preset voltage value: Uₐ₂ > 0 V. To be specific, the non-inverting input signal for the comparator T1 is greater than the inverting input signal, and output of the comparator T1 is a high level.

If a reverse overcurrent flows into the bridgeless PFC circuit 410, the potential Uₐ₂ at the bridge arm midpoint a2 is less than the opposite number of the preset voltage value: Uₐ₂ < 0 V. To be specific, the non-inverting input signal for the comparator T1 is less than the inverting input signal, and output of the comparator T1 is a low level.

In this way, when a reverse overcurrent flows into the bridgeless PFC circuit 410, an output signal of the comparator T1 is inverted from a high level to a low level. The inverted signal serves as a trigger condition for the controller 420, so that the controller 420 generates a drive signal to turn off the low-frequency switching transistor S2.

It should be understood that the foregoing specific structure of the voltage detection circuit 413 is merely an example. In this embodiment of this application, a structure of the voltage detection circuit 413 only needs to enable the controller 420 to determine the voltage at the bridge arm midpoint a2.

FIG. 11 is a diagram of a structure of an example bridgeless PFC circuit 410 according to an embodiment of this application.

A difference from the embodiment shown in FIG. 9 lies in that, in the embodiment shown in FIG. 11, the bridgeless PFC circuit 410 is grounded through the bridge arm midpoint a2. To be specific, the cathode potential U_{D2 cathode} of the diode D2 is 0 V. In this case, the controller 420 is configured to: when the phase voltage of the alternating current power supply AC falls within one half-cycle and the low-frequency switching transistor S2 is turned on, turn off the low-frequency switching transistor S2 when the anode potential U_{D2 anode} of the diode D2 is greater than the preset voltage value, to implement reverse overcurrent protection for the low-frequency switching transistor S2.

Specifically, similar to the embodiment shown in FIG. 9, when the phase voltage of the alternating current power supply AC falls within one half-cycle and the low-frequency switching transistor S2 is turned on, if no reverse overcurrent flows into the bridgeless PFC circuit 410, the anode potential U_{D2 anode} of the diode D2 is less than the cathode potential U_{D2 cathode} of the diode D2, U_{D2 anode} - U_{D2 cathode} < the preset voltage value, and U_{D2 cathode} - U_{D2} anode > - the preset voltage value. Because the cathode potential U_{D2} cathode of the diode D2 is 0 V, the anode potential U_{D2 anode} of the diode D2 < the preset voltage value.

On the contrary, if a reverse overcurrent flows into the bridgeless PFC circuit 410, the anode potential U_{D2 anode} of the diode D2 increases, so that U_{D2 anode} - U_{D2 cathode} > the preset voltage value, and U_{D2 cathode} - U_{D2 anode} - the preset voltage value. Similarly, because the cathode potential U_{D2 cathode} of the diode D2 is 0 V, the anode potential U_{D2 anode} of the diode D2 > the preset voltage value.

It can be learned from the foregoing analysis that, when the bridge arm midpoint a2 is grounded, in other words, when the cathode of the diode D2 is grounded, the controller 420 may determine, by detecting the anode potential U_{D2 anode} of the diode D2, whether the difference between the anode potential and the cathode potential of the diode D2 meets the foregoing preset condition. Compared with a manner in which the controller 420 detects voltages at two endpoints, that is, the cathode and the anode, of the diode D2 to determine whether the difference between the anode potential and the cathode potential of the diode D2 meets the foregoing preset condition, the foregoing manner better helps reduce complexity of a circuit design for voltage sampling on the diode D2, and further reduce costs of the power module.

**Case 2: The controller 420 turns off the low-frequency switching transistor S1 when the phase voltage of the alternating current power supply AC falls within the other half-cycle.**

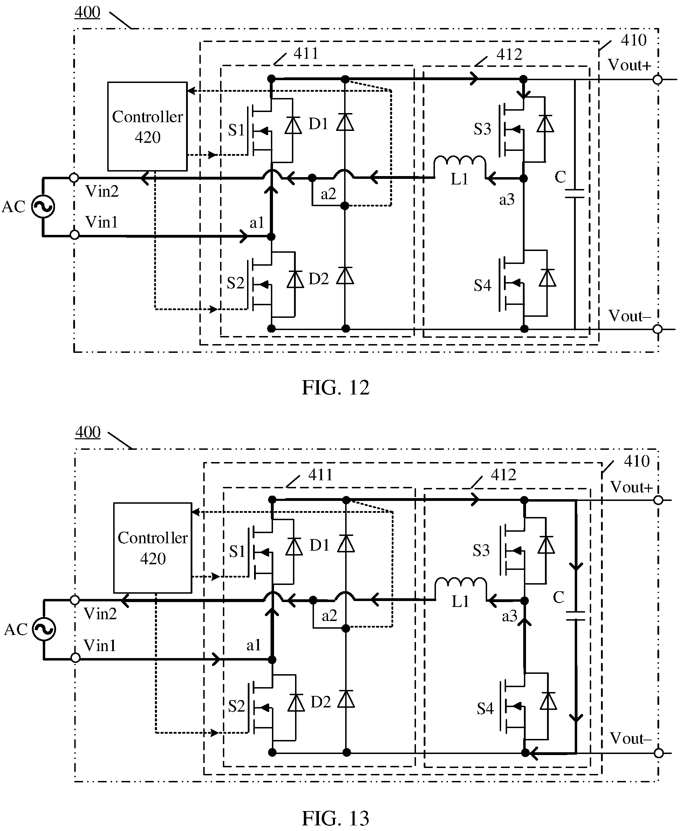

FIG. 12 to FIG. 14 are diagrams of a structure of another example power module according to an embodiment of this application.

With reference to FIG. 12 and FIG. 13, an example in which the high-frequency module 412 includes one high-frequency bridge arm and one inductor L1 is still used. When the phase voltage of the alternating current power supply AC falls within the other half-cycle and the low-frequency switching transistor S1 is turned on, as shown in FIG. 12, an alternating current output by the alternating current power supply AC sequentially flows through the input terminal Vin1 → the low-frequency switching transistor S1 → the high-frequency switching transistor S3 → the inductor L1 → the input terminal Vin2, to form an operation loop of the inductor L1 for energy storage within the other half-cycle. Alternatively, as shown in FIG. 13, an alternating current output by the alternating current power supply AC sequentially flows through the input terminal Vin1 → the low-frequency switching transistor S1 → the capacitor C → the high-frequency switching transistor S4 → the inductor L1 → the input terminal Vin2, to form an operation loop of the inductor L1 for energy output within the other half-cycle.

In the operation loops of the inductor L1 for energy storage and energy output, the anode potential U_{D1 anode} of the diode D1 is less than the cathode potential U_{D1 cathode} of the diode D1, and the diode D1 is reversely cut off. In this case, U_{D1 anode} - U_{D1 cathode} < the preset voltage value, and U_{D1 cathode} - U_{D1 anode} > - the preset voltage value. To be specific, absolute values of voltages at two ends of the diode D1 are less than the preset voltage value.

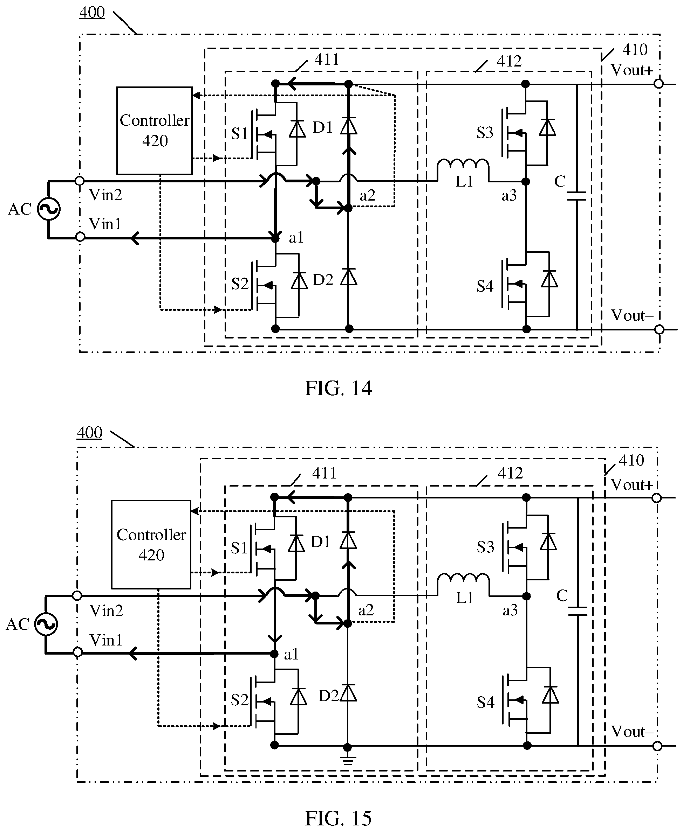

However, as shown in FIG. 14, if a reverse overcurrent is generated at the alternating current power supply AC connected to the power module 400, the reverse overcurrent sequentially flows through the input terminal Vin2, the diode D1, the low-frequency switching transistor S1, and the input terminal Vin1, to form an overcurrent loop.

During the formation of the overcurrent loop, the anode potential U_{D1 anode} of the diode D1 increases, and/or the cathode potential U_{D1 cathode} of the diode D1 decreases, and the anode potential U_{D1 anode} of the diode D1 is greater than the cathode potential U_{D1 cathode} of the diode D1, so that the diode D1 is turned on in a forward direction. In the foregoing process in which the diode D1 is turned on in the forward direction due to the reverse overcurrent, the anode potential U_{D1 anode} of the diode D1 increases, and/or the cathode potential U_{D1 cathode} of the diode D1 decreases, so that U_{D1 anode} - U_{D1 cathode} > the preset voltage value, and U_{D1 cathode} - U_{D1 anode} < - the preset voltage value. To be specific, absolute values of voltages at two ends of the diode D1 are greater than the preset voltage value.

It can be learned from the foregoing analysis that, when the phase voltage of the alternating current power supply AC falls within the other half-cycle, when the controller 420 detects that the difference between the anode potential and the cathode potential of the diode D1 is greater than the preset voltage value or less than the opposite number of the preset voltage value, in other words, when the difference between the anode potential and the cathode potential of the diode D1 meets the foregoing preset condition, the controller 420 may determine that the diode D1 is turned on in the forward direction, and therefore determine that a reverse overcurrent flows into the bridgeless PFC circuit 410 through the two input terminals Vin1 and Vin2. Further, the controller 420 turns off the low-frequency switching transistor S1, to implement reverse overcurrent protection for the low-frequency switching transistor S1.

Further, in some embodiments, the controller 420 is further configured to: when the phase voltage of the alternating current power supply AC falls within the other half-cycle, turn on the low-frequency switching transistor S1 after the low-frequency switching transistor S1 is turned off for preset duration, to resume normal operation of the bridgeless PFC circuit 410 and improve running stability of the power module 400. For specific descriptions, refer to related descriptions in the case in which the phase voltage of the alternating current power supply AC falls within one half-cycle. Details are not described herein again.

It should be understood that, similar to the case in which the controller 420 determines whether the difference between the anode potential and the cathode potential of the diode D2 meets the preset condition, when the bridgeless PFC circuit 410 is grounded through different endpoints, the controller 420 may directly determine, based on the cathode potential or the anode potential of the diode D1, whether the difference between the anode potential and the cathode potential of the diode D1 meets the foregoing preset condition.

For example, FIG. 15 is a diagram of a structure of an example power module 400 according to an embodiment of this application.

As shown in FIG. 15, in some embodiments, the anode of the diode D2 is grounded. To be specific, a potential at an output end that is in the bridgeless PFC circuit and that is connected to the output terminal Vout- of the power module 400 is 0 V, and the cathode potential U_{D1 cathode} of the diode D1 is a potential at the other output end that is in the bridgeless PFC circuit and that is connected to the output terminal Vout+ of the power module 400. In this case, the controller 420 is configured to: when the phase voltage of the alternating current power supply AC falls within the other half-cycle and the low-frequency switching transistor S1 is turned on, turn off the low-frequency switching transistor S1 when the potential at the bridge arm midpoint a2 of the low-frequency bridge arm 4112 is greater than a sum of the preset voltage value and the potential at the other output end that is in the bridgeless PFC circuit 410 and that is connected to the output terminal Vout+ of the power module 400, to implement reverse overcurrent protection for the low-frequency switching transistor S1.

Specifically, with reference to the embodiments shown in FIG. 12 and FIG. 13, it can be learned that, when the phase voltage of the alternating current power supply AC falls within the other half-cycle and the low-frequency switching transistor S1 is turned on, if no reverse overcurrent flows into the bridgeless PFC circuit 410, the anode potential U_{D1 anode} of the diode D1 is less than the cathode potential U_{D1 cathode} of the diode D1, U_{D1 anode} - U_{D1 cathode} < the preset voltage value, and U_{D1 cathode} - U_{D1 anode} > - the preset voltage value. Because the cathode potential U_{D1 cathode} of the diode D1 is the potential at the other output end that is in the bridgeless PFC circuit 410 and that is connected to the output terminal Vout+ of the power module 400, the anode potential U_{D1 anode} of the diode D1 is less than the sum of the preset voltage value and the potential at the other output end that is in the bridgeless PFC circuit 410 and that is connected to the output terminal Vout+ of the power module 400. In other words, the potential Uₐ₂ at the bridge arm midpoint a2 is less than the sum of the preset voltage value and the potential at the other output end that is in the bridgeless PFC circuit 410 and that is connected to the output terminal Vout+ of the power module 400.

In addition, because the potential at the one output end that is in the bridgeless PFC circuit 410 and that is connected to the output terminal Vout- of the power module 400 is 0 V, the potential at the other output end that is in the bridgeless PFC circuit 410 and that is connected to the output terminal Vout+ of the power module 400, that is, the cathode potential of the diode D1, is equal to an output voltage of the bridgeless PFC circuit 410. Therefore, the potential Uₐ₂ at the bridge arm midpoint a2 is less than a sum of the preset voltage value and the output voltage of the bridgeless PFC circuit 410.

With reference to the embodiment shown in FIG. 14, it can be learned that, if a reverse overcurrent flows into the bridgeless PFC circuit 410, the anode potential U_{D1 anode} of the diode D1 increases, so that U_{D1 anode} - U_{D1 cathode} > the preset voltage value, and U_{D1 cathode} - U_{D1 anode} < - the preset voltage value. Similarly, because the cathode potential U_{D1 cathode} of the diode D1 is the potential at the other output end that is in the bridgeless PFC circuit 410 and that is connected to the output terminal Vout+ of the power module 400, the anode potential U_{D1 anode} of the diode D1 is greater than the sum of the preset voltage value and the potential at the other output end that is in the bridgeless PFC circuit 410 and that is connected to the output terminal Vout+ of the power module 400. In other words, the potential Uₐ₂ at the bridge arm midpoint a2 is greater than the sum of the preset voltage value and the potential at the other output end that is in the bridgeless PFC circuit 410 and that is connected to the output terminal Vout+ of the power module 400. In other words, the potential Uₐ₂ at the bridge arm midpoint a2 is greater than a sum of the preset voltage value and an output voltage of the bridgeless PFC circuit 410.

It can be learned from the foregoing analysis that, when the anode of the diode D2 is grounded, the controller 420 may determine, by detecting the potential Uₐ₂ at the bridge arm midpoint a2, whether the difference between the anode potential and the cathode potential of the diode D1 meets the foregoing preset condition. This helps reduce complexity of a circuit design for voltage sampling on the diode D1, and further reduce costs of the power module 400.

For related descriptions of detecting, by the controller 420, the voltage Uₐ₂ at the bridge arm midpoint a2, refer to the embodiment shown in FIG. 10. Details are not described herein again.

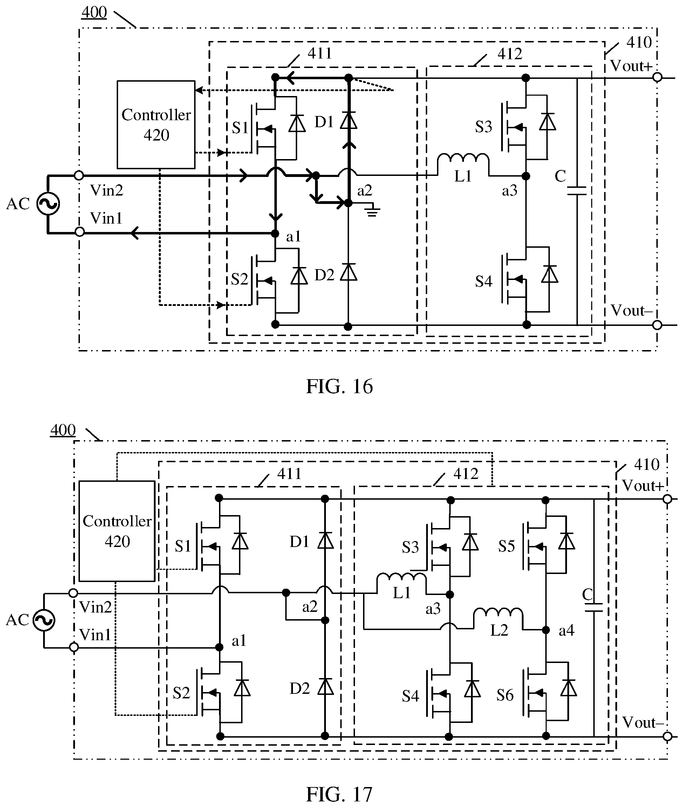

FIG. 16 is a diagram of a structure of another example power module 400 according to an embodiment of this application.

A difference from the embodiment shown in FIG. 15 lies in that, in the embodiment shown in FIG. 16, the bridgeless PFC circuit 410 is grounded through the bridge arm midpoint a2, and the anode potential U_{D1 anode} of the diode D1 is 0 V. In this case, the controller 420 is configured to: when the phase voltage of the alternating current power supply AC falls within the other half-cycle and the low-frequency switching transistor S1 is turned on, turn off the low-frequency switching transistor S1 when the cathode potential U_{D1 cathode} of the diode D1 is less than the opposite number of the preset voltage value, to implement reverse overcurrent protection for the low-frequency switching transistor S1.

Specifically, similar to the embodiment shown in FIG. 15, when the phase voltage of the alternating current power supply AC falls within the other half-cycle and the low-frequency switching transistor S1 is turned on, if no reverse overcurrent flows into the bridgeless PFC circuit 410, the anode potential U_{D1 anode} of the diode D1 is less than the cathode potential U_{D1 cathode} of the diode D1, U_{D1 anode} - U_{D1 cathode} < the preset voltage value, and U_{D1 cathode} - U_{D1 anode} > - the preset voltage value. Because the anode potential U_{D1 anode} of the diode D1 is 0 V, the cathode potential U_{D1 cathode} of the diode D1 is greater than the opposite number of the preset voltage value: U_{D1 cathode} > - the preset voltage value.

On the contrary, if a reverse overcurrent flows into the bridgeless PFC circuit 410, the cathode potential U_{D1 cathode} of the diode D1 decreases, so that U_{D1 anode} - U_{D1 cathode} > the preset voltage value, and U_{D1 cathode} - U_{D1 anode} < - the preset voltage value. Similarly, because the anode potential U_{D1 anode} of the diode D1 is 0 V, the cathode potential U_{D1 cathode} of the diode D1 is less than the opposite number of the preset voltage value: U_{D1 cathode} < - the preset voltage value.

It can be learned from the foregoing analysis that, when the bridge arm midpoint a2 is grounded, in other words, when the anode of the diode D1 is grounded, the controller 420 may determine, by detecting the cathode potential U_{D1 cathode} of the diode D1, whether the difference between the anode potential and the cathode potential of the diode D1 meets the foregoing preset condition. This better helps reduce complexity of a circuit design for voltage sampling on the diode D1, and further reduce costs of the power module 400.

With reference to the accompanying drawings, the foregoing describes different cases in which the controller 420 turns off the low-frequency switching transistor S2 and the low-frequency switching transistor S1 separately. The following further describes the structure of the power module 400 in detail.

FIG. 17 is a diagram of a structure of still another example power module 400 according to an embodiment of this application.

A difference from the high-frequency module 412 including one high-frequency bridge arm and the inductor L1 in FIG. 6 to FIG. 16 lies in that, in the embodiment shown in FIG. 17, the high-frequency module 412 includes two high-frequency bridge arms and two inductors L1 and L2. One high-frequency bridge arm includes two high-frequency switching transistors S3 and S4 that are connected in series. The other high-frequency bridge arm includes two high-frequency switching transistors S5 and S6 that are connected in series. The two high-frequency bridge arms are connected in parallel and then connected between the two output terminals Vout+ and Vout-. In addition, a bridge arm midpoint a3 of one high-frequency bridge arm is connected to the input terminal Vin2 through the inductor L1, and a bridge arm midpoint a4 of the other high-frequency bridge arm is connected to the input terminal Vin2 through the inductor L2.

During specific implementation, the two high-frequency bridge arms operate with a phase difference of 180°. An operation principle of each high-frequency bridge arm in a case in which the phase voltage of the alternating current power supply AC falls within different half-cycles is the same as the operation principle of the one high-frequency bridge arm included in the high-frequency module 412 shown in FIG. 6 to FIG. 16. For specific descriptions, refer to the embodiments shown in FIG. 6 to FIG. 16. Details are not described herein again.

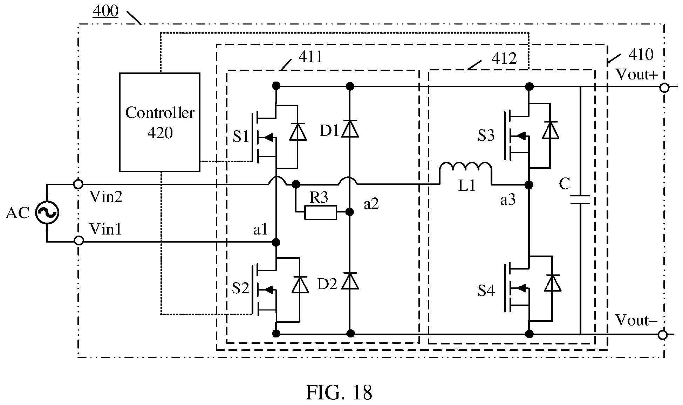

FIG. 18 is a diagram of a structure of another power module 400 according to an embodiment of this application.

A difference from the embodiments shown in FIG. 5 to FIG. 17 lies in that, in the embodiment shown in FIG. 18, the low-frequency module 411 further includes a current-limiting resistor R3. The current-limiting resistor R3 is connected in series between the input terminal Vin2 and the bridge arm midpoint a2 of the low-frequency bridge arm 4112. The current-limiting resistor R3 is configured to suppress a surge current in the bridgeless PFC circuit 410 when a large forward surge current flows into the bridgeless PFC circuit 410 through the two input terminals Vin1 and Vin2.

Specifically, as shown in FIG. 18, an example in which the high-frequency module 412 includes one high-frequency bridge arm and one inductor L1 is still used. When the phase voltage of the alternating current power supply AC falls within one half-cycle and the low-frequency switching transistor S2 is turned on, a large forward surge current sequentially flows through the input terminal Vin2 → the current-limiting resistor R3 → the diode D1 → the capacitor C → the low-frequency switching transistor S2 → the input terminal Vin1. The current-limiting resistor R3 is configured to limit the surge current that flows through the current-limiting resistor R3, to implement surge protection for the bridgeless PFC circuit 410. The current-limiting resistor R3 may be, for example, a thermistor or a varistor.

Similarly, when the phase voltage of the alternating current power supply AC falls within the other half-cycle and the low-frequency switching transistor S1 is turned on, a large forward surge current sequentially flows through the input terminal Vin1 → the low-frequency switching transistor S1 → the capacitor C → the diode D2 → the current-limiting resistor R3 → the input terminal Vin2. The current-limiting resistor R3 is configured to limit the surge current that flows through the current-limiting resistor R3, to implement surge protection for the bridgeless PFC circuit.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power module, wherein the power module comprises two input terminals, a bridgeless power factor correction, PFC circuit, and a controller, the two input terminals are configured to connect to an alternating current power supply, the bridgeless PFC circuit comprises a low-frequency module and a high-frequency module, the low-frequency module and the high-frequency module are connected in parallel, and a switching frequency of a switching transistor in the low-frequency module is less than a switching frequency of a switching transistor in the high-frequency module;
the low-frequency module comprises two low-frequency bridge arms that are connected in parallel, one low-frequency bridge arm comprises two low-frequency switching transistors that are connected in series, the other low-frequency bridge arm comprises two diodes that are connected in series, a bridge arm midpoint of the one low-frequency bridge arm is connected to one input terminal, and a bridge arm midpoint of the other low-frequency bridge arm and the high-frequency module are connected to the other input terminal; and
the controller is configured to:
turn off the low-frequency switching transistor in the one low-frequency bridge arm when an anode potential of the diode in the other low-frequency bridge arm and a cathode potential of the diode meet a preset condition, wherein the preset condition comprises at least one of the following conditions:
a difference obtained by subtracting the cathode potential of the diode from the anode potential of the diode is greater than a preset voltage value, or a difference obtained by subtracting the anode potential of the diode from the cathode potential of the diode is less than an opposite number of the preset voltage value.

2. The power module according to claim 1, wherein a drain of one low-frequency switching transistor is connected to a source of the other low-frequency switching transistor, a cathode of one diode is connected to an anode of the other diode, a source of the one low-frequency switching transistor and an anode of the one diode are connected and serve as one output end in a group of output ends of the bridgeless PFC circuit, and a drain of the other low-frequency switching transistor and a cathode of the other diode are connected and serve as the other output end in the group of output ends of the bridgeless PFC circuit; and
a phase voltage of the alternating current power supply comprises two half-cycles, and the controller is configured to:
when the phase voltage of the alternating current power supply falls within one half-cycle and the one low-frequency switching transistor is turned on, turn off the one low-frequency switching transistor when an anode potential of the one diode and a cathode potential of the one diode meet the preset condition; or
when the phase voltage of the alternating current power supply falls within the other half-cycle and the other low-frequency switching transistor is turned on, turn off the other low-frequency switching transistor when an anode potential of the other diode and a cathode potential of the other diode meet the preset condition.

3. The power module according to claim 2, wherein the anode of the one diode is grounded;
that the controller is configured to turn off the one low-frequency switching transistor when an anode potential of the one diode and a cathode potential of the one diode meet the preset condition comprises:
turning off the one low-frequency switching transistor when a potential at the bridge arm midpoint of the other low-frequency bridge arm is less than the opposite number of the preset voltage value; and
that the controller is configured to turn off the other low-frequency switching transistor when an anode potential of the other diode and a cathode potential of the other diode meet the preset condition comprises:
turning off the other low-frequency switching transistor when a potential at the bridge arm midpoint of the other low-frequency bridge arm is greater than a sum of the preset voltage value and a potential at the other output end of the bridgeless PFC circuit.

4. The power module according to claim 2, wherein the bridge arm midpoint of the other low-frequency bridge arm is grounded;
that the controller is configured to turn off the one low-frequency switching transistor when an anode potential of the one diode and a cathode potential of the one diode meet the preset condition comprises:
turning off the one low-frequency switching transistor when the anode potential of the one diode is greater than the preset voltage value; and
that the controller is configured to turn off the other low-frequency switching transistor when an anode potential of the other diode and a cathode potential of the other diode meet the preset condition comprises:
turning off the other low-frequency switching transistor when the cathode potential of the other diode is less than the opposite number of the preset voltage value.

5. The power module according to any one of claims 2 to 4, wherein the controller is further configured to:
when the phase voltage of the alternating current power supply falls within the one half-cycle, turn on the one low-frequency switching transistor after the one low-frequency switching transistor is turned off for preset duration; or
when the phase voltage of the alternating current power supply falls within the other half-cycle, turn on the other low-frequency switching transistor after the other low-frequency switching transistor is turned off for the preset duration.

6. The power module according to any one of claims 2 to 5, wherein the high-frequency module comprises at least one high-frequency bridge arm, at least one inductor, and a capacitor;
each of the at least one high-frequency bridge arm comprises two high-frequency switching transistors that are connected in series, and each high-frequency bridge arm is connected in parallel to the other low-frequency bridge arm and the capacitor; and
the at least one high-frequency bridge arm is in a one-to-one correspondence with the at least one inductor, and a bridge arm midpoint of each high-frequency bridge arm is connected to the other input terminal through a corresponding inductor.

7. The power module according to any one of claims 2 to 6, wherein the low-frequency module further comprises a current-limiting resistor, and the current-limiting resistor is connected in series between the other input terminal and the bridge arm midpoint of the other low-frequency bridge arm.

8. The power module according to any one of claims 2 to 7, wherein
when the phase voltage of the alternating current power supply falls within the one half-cycle and the one low-frequency switching transistor is turned on, a current output by the alternating current power supply sequentially flows through the other input terminal, the high-frequency module, the one low-frequency switching transistor, and the one input terminal, to form an operation loop of the bridgeless PFC circuit within the one half-cycle; or
when a current output by the alternating current power supply sequentially flows through the one input terminal, the one low-frequency switching transistor, the one diode, and the other input terminal to form an overcurrent loop of the bridgeless PFC circuit within the one half-cycle, the anode potential of the one diode and the cathode potential of the one diode meet the preset condition.

9. The power module according to any one of claims 2 to 8, wherein
when the phase voltage of the alternating current power supply falls within the other half-cycle and the other low-frequency switching transistor is turned on, an alternating current output by the alternating current power supply sequentially flows through the one input terminal, the other low-frequency switching transistor, and the high-frequency module, to form an operation loop of the bridgeless PFC circuit within the other half-cycle; or
when a current output by the alternating current power supply sequentially flows through the other input terminal, the other diode, the other low-frequency switching transistor, and the one input terminal to form an overcurrent loop of the bridgeless PFC circuit within the other half-cycle, the anode potential of the other diode and the cathode potential of the other diode meet the preset condition.
